# EUROPÄISCHE PATENTSCHRIFT

(11) **EP 1 520 253 B1**
(45) Veröffentlichungstag und Bekanntmachung des Hinweises auf die Patenterteilung: **26.09.2012**
(21) Anmeldenummer: 03762594.4
(22) Anmeldetag: 02.07.2003
(51) Int. Cl.: G06K 19/077

(54) **VERFAHREN ZUR HERSTELLUNG VON ELEKTRISCH LEITFÄHIGEN VERBINDUNGEN AUF CHIPKARTEN**
METHOD FOR THE PRODUCTION OF ELECTRICALLY-CONDUCTING CONNECTIONS ON CHIPCARDS
PROCEDE POUR ETABLIR DES CONNEXIONS ELECTROCONDUCTRICES SUR DES CARTES A PUCE

(30) Priorität: 03.07.2002 DE 10229902
(43) Veröffentlichungstag der Anmeldung: 06.04.2005
(73) Patentinhaber: Giesecke & Devrient GmbH, 81677 München (DE)
(72) Erfinder: RIEDL, Josef, 85395 Attenkirchen (DE); WELLING, Ando, 84424 Isen (DE)
(74) Vertreter: Höhfeld, Jochen
(86) Internationale Anmeldenummer: PCT/EP2003/007070
(87) Internationale Veröffentlichungsnummer: WO 2004/006173

(56) Entgegenhaltungen:
- DE-A- 19 709 985
- US-A- 5 647 122

## Beschreibung

Die Erfindung betrifft ein Verfahren zur Herstellung einer elektrisch leitfähigen Verbindung zwischen Spulenkontaktflächen und Chipmodul eines Datenträgers, insbesondere einer Chipkarte. Ferner betrifft die Erfindung die Verwendung eines Klebstoffs zur Herstellung einer elektrisch leitfähigen Verbindung zwischen Spulenkontaktflächen und Chipmodul eines Datenträgers, insbesondere einer Chipkarte sowie einen nach dem Verfahren hergestellten Datenträger.

Chipkarten werden in der heutigen Zeit in allen Bereichen des täglichen Lebens verwendet. Sie finden Einsatz auf dem Gebiet des bargeldlosen Zahlungsverkehrs, zur Kontrolle von Zugangsberechtigungen, als Datenträger für persönliche Merkmale, als Ausweiskarten, usw.. Bei einem Teil der im Umlauf befindlichen Chipkarten erfolgt der Daten- und Energieaustausch berührungslos durch im Kartenkörper angeordnete Antennen mittels induktiver Kopplung. Die Antennen sind als Spulen ausgebildet und beispielsweise-auf den Kartenkörper aufgedruckt oder aus Metall ausgestanzt. Ein Großteil der verwendeten Chipkarten, die sogenannten "Dual-Interface-Karten", eignen sich sowohl zum berührungslosen Datenaustausch als auch - über die vorhandenen Kontaktflächen - zur Verwendung in Lesegeräten.

Zur Herstellung der elektrisch leitenden Verbindung zwischen den Spulenkontaktflächen der Antenne und dem Chipmodul werden häufig anisotrop leitende Klebstoffe eingesetzt. Diese Klebstoffe weisen mikroskopisch kleine Metallpartikel, im allgemeinen Silberpartikel auf, welche von einer nichtleitenden Trägermasse umgeben sind. Bei Druckbeaufschlagung bilden die Metallpartikel in Druckrichtung einen leitfähigen Pfad, während quer zur Druckrichtung das Material weiterhin einen hohen Widerstand aufweist und daher in dieser Richtung nicht leitet.

In der Praxis weist die Verwendung eines anisotrop leitenden Klebstoffes unter anderem den Nachteil auf, daß der Klebstoff teuer ist und die entstandenen Klebestellen bei mechanischer Belastung nur eine unzureichend leitende Verbindung zwischen Chipmodul und Spulenkontaktflächen bilden. Im Zusammenhang mit gedruckten Antennen läßt sich überdies ein anisotroper Klebstoff nicht einsetzen, da der zwischen Chipmodul und Spulenkontaktfläche aufgebaute Druck nicht ausreicht, einen dauerhaft leitfähigen Pfad zu bilden.

Aus dem Stand der Technik, wie z. B. der EP 0 682 321 ist es bekannt, einen elektrisch leitenden Klebstoff einzusetzen. Ein Nachteil eines derartigen Klebstoffs besteht darin, daß bei dessen flächiger Aufbringung nicht nur zwischen Chipmodul und jeweiliger Spulenkontaktfläche eine elektrisch leitfähige Verbindung entsteht, sondern auch zwischen beiden Spulenkontaktflächen der Antenne, welches zum Kurzschluß der Antenne führt. Daher ist es vorgesehen, den elektrisch leitenden Klebstoff derart aufzubringen, daß beide Spulenkontaktflächen isoliert voneinander bleiben. Dies wird erreicht durch punktförmiges Auftragen des Klebstoffs oder durch nachträgliches punktuelles Entfernen des flächig aufgetragenen Klebstoffes. In jedem Fall ist jedoch das Herstellen der Klebeverbindung aufwändig und daher mit erhöhten Kosten verbunden.

Aufgabe der Erfindung ist es daher, ein Verfahren zur Herstellung einer elektrisch leitfähigen Verbindung zwischen Spulenkontaktflächen und Chipmodul eines Datenträgers, insbesondere einer Chipkarte bereitzustellen, welches zu einer elektrisch gut leitenden Verbindung zwischen Chipmodul und Spulenkontaktflächen fühlt, die Spulenkontaktflächen ausreichend voneinander isoliert und gleichzeitig einfach zu realisieren ist.

Die Aufgabe wird durch die in den Ansprüchen angegebenen Merkmale gelöst.

Der Grundgedanke der Erfindung basiert auf dem Einsatz eines nur begrenzt elektrisch leitfähigen Klebstoffs zur Herstellung einer Klebeverbindung zwischen den Spulenkontaktflächen und dem Chipmodul. Der Klebstoff kann derart aufgetragen werden, daß die Spulenkontaktflächen und das Chipmodul über eine einzige Klebeverbindung miteinander verbunden sind. Die spezifische elektrische Leitfähigkeit des Klebstoffs wird derart gewählt, daß sich nach Auftragung des Klebstoffs zwischen Chipmodul und jeweiliger Spulenkontaktfläche, deren Abstand typischerweise ca. 30 µm beträgt, ein geringer Widerstand von beispielsweise 3 Ω bildet. Die durch eine vollflächige Auftragung des Klebstoffs ebenfalls entstehende Verbindung beider Spulenkontaktflächen miteinander ist jedoch aufgrund des um ein Vielfaches größeren Abstands der Spulenkontaktflächen und deren geringer Querschnittsfläche hochohmig; der Widerstand beträgt typischerweise 1000 Q und mehr. Auf diese Weise kann der Klebstoff in einem Arbeitsschritt aufgetragen werden, ohne daß besondere Vorkehrungen zur Verhinderung eines Kurzschlusses zwischen den Spulenkontaktflächen getroffen werden müßten.

Es ist weiterhin denkbar, den Klebstoff nicht vollflächig in dem Hohlraum zwischen den Spulenkontaktflächen und dem Chipmodul aufzutragen, sondern in Form von Klebepunkten, welche jeweils eine Spulenkontaktfläche mit dem Chipmodul elektrisch leitend verbinden.

Weitere Eigenschaften und Vorteile der Erfindung ergeben sich aus der nachfolgenden Beschreibung verschiedener Ausführungsbeispiele, die anhand der Zeichnungen näher erläutert sind.

Es zeigen
- Fig. 1: eine Ansicht einer Chipkarte,
- Fig. 2: einen schematischen Querschnitt durch ein Substrat einer Chipkarte unter Verwendung eines Klebstoffs nach einer ersten Ausgestaltung der Erfindung,
- Fig. 3: einen schematischen Querschnitt durch ein Substrat einer Chipkarte, bei dem nach einer zweiten Ausgestaltung der Erfindung der Klebstoff in Form von Klebepunkten aufgetragen ist.

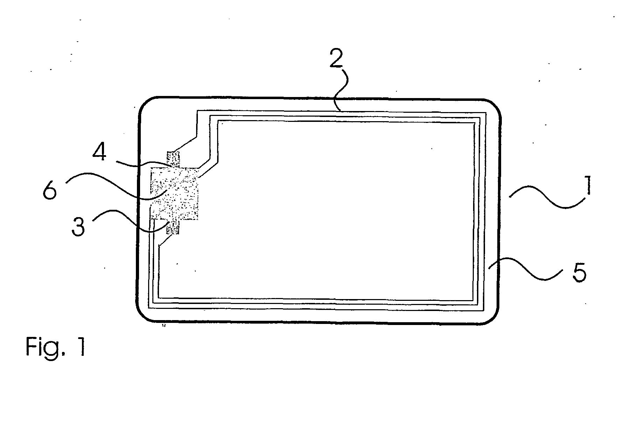

Fig. 1 stellt eine Chipkarte 1 dar mit einer darauf angeordneten Spule 2, welche als Antenne dient und elektrisch leitend mit den Spulenkontaktflächen 3, 4 verbunden ist. Träger dieser Anordnung ist das Substrat 5. Die Chipkarte 1 weist ferner ein Chipmodul 6 auf, welches beispielsweise in einer Aussparung, einer sogenannten Kavität, des Substrates 5 aufgenommen ist und mit den Spulenkontaktflächen 3, 4 durch einen Klebstoff (nicht dargestellt) leitend verbunden ist.

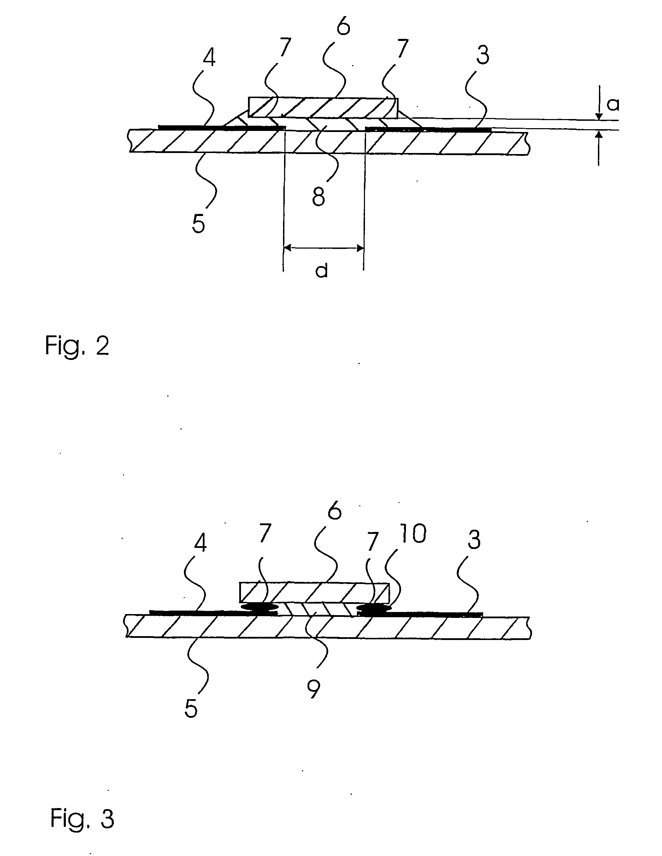

Fig. 2 zeigt einen nicht maßstabsgetreuen Querschnitt des Substrats 5 einer Chipkarte 1. Die Spulenkontaktflächen 3, 4 sind auf dem Substrat 5 angeordnet, können aber auch bündig mit der Oberfläche des Substrats 5 abschließen oder teilweise in das Substrat 5 eingebettet sein. In der dargestellten Anordnung ist das Chipmodul 6 oberhalb der Spulenkontaktflächen 3, 4 positioniert, wobei Kontaktelemente 7 des Chipmoduls 6 den Spulenkontaktflächen 3, 4 gegenüber liegen. Ein erfindungsgemäß begrenzt leitender Klebstoff 8 wird nach einer ersten Ausgestaltung der Erfindung auf die Spulenkontaktflächen 3, 4 aufgetragen und verbindet diese mit dem Chipmodul 6. Es ist selbstverständlich auch denkbar, den Klebstoff 8 zuerst auf das Chipmodul 6 aufzutragen und anschließend die Verbindung mit den Spulenkontaktflächen 3, 4 herzustellen.

Vorzugsweise ist der Klebstoff 8 ein Heißklebstoff, so daß sich eine mechanisch besonders stabile Verbindung zwischen Chipmodul 6 und Spulenkontaktflächen 3, 4 ergibt.

Gemäß einer weiteren Ausgestaltung der Erfindung werden die Spulenkontaktflächen 3, 4 zusätzlich mechanisch voneinander isoliert. Hierzu kann der vollflächig aufgetragene Klebstoff 8 zwischen den Spulenkontaktflächen 3, 4 teilweise nachträglich entfernt werden oder getrennt auf jede Spulenkontaktfläche 3, 4 aufgetragen werden, derart, daß der Klebstoff 8 keine mechanische Brücke zwischen den Spulenkontaktflächen 3, 4 bildet. Es kann beispielsweise eine Nut quer zur Klebstoffebene gefräst werden, durch die der Klebstoff 8 vollständig oder zumindest zu einem überwiegenden Teil abgetragen wird. Auf diese Weise wird die elektrische Isolierung der Spulenkontaktflächen 3, 4 noch erhöht.

Die Geometrie der Anordnung sieht vor, daß der Abstand a zwischen Kontaktelementen 7 des Chipmoduls 6 und jeweils einer Spulenkontaktfläche 3, 4 um ein Vielfaches kleiner ist als der Abstand d zwischen beiden Spulenkontaktflächen. Während für a ein Wert von ca. 30 µm angegeben werden kann, beträgt d je nach Aufbau der verwendeten Chipkarte ca. 8 mm. Vorzugsweise wird die spezifische elektrische Leitfähigkeit des leitenden Klebstoffs 8 derart gewählt, daß der Widerstand zwischen einem Kontaktelement 7 des Chipmoduls 6 und einer Spulenkontaktfläche 3, 4 einen geringen Wert aufweist (typisch: 3 Ω oder darunter) und sich zwischen zwei Spulenkontaktflächen 3, 4 ein hochohmiger Widerstand (typisch: 1000 Ω oder mehr) bildet, welcher einen Antennenkurzschluß sicher verhindert.

Eine weitere Möglichkeit der Herstellung einer elektrisch leitenden Verbindung zwischen Chipmodul 6 und Spulenkontaktfläche 3, 4 besteht, wie in Fig. 3 dargestellt, darin, einerseits die Verbindung zwischen Chipmodul 6 und Substrat 5 durch einen nichtleitenden Klebstoff 9 herzustellen, während andererseits ausschließlich an den Spulenkontaktflächen 3, 4 sowie an den Kontaktelementen 7 des Chipmoduls 6 Klebstoffpunkte 10 aus erfindungsgemäß begrenzt leitendem Klebstoff 8 angeordnet werden. Die spezifische elektrische Leitfähigkeit des begrenzt leitenden Klebstoffs 8 wird vorzugsweise derart gewählt, daß der jeweils resultierende Gesamtwiderstand zwischen Chipmodul 6 und Spulenkontaktfläche 3, 4 niederohmig ist und im wesentlichen 3 Ω nicht überschreitet. Anstelle eines Verfahren, bei dem nichtleitender Klebstoff 9 eingesetzt wird, kann natürlich auch jedes beliebige andere Verfahren, wie beispielsweise Schmelzen oder Ultraschallschwei-βen zum Einsatz kommen, welches für eine ausreichende mechanische Stabilität der Verbindung zwischen Chipmodul 6 und Substrat 5 sorgt.

Die Klebstoffpunkte 10 können beispielsweise nach dem Fräsen einer Chipmodulkavität aufgebracht werden. Es ist auch denkbar, die Klebstoffpunkte 10 im Siebdruckverfahren vor der Kartenlaminierung anzubringen. An den Stellen, an denen die Klebstoffpunkte 10 angeordnet werden sollen, kann der nichtleitende Klebstoff 9 ausgespart werden oder auch nach dem Auftragen durch ein geeignetes Verfahren entfernt werden.

Ferner ist es möglich, die Klebstoffpunkte 10 aus dem begrenzt leitenden Klebstoff 8 auszustanzen und die Klebstoffpunkte 10 anschließend auf die Chipmodule 6 aufzubringen. Es kann ein hitzeaktivierbares Klebeband zur Fixierung der Chipmodule 6 im Kartenkörper verwendet werden, so daß die ausgestanzten Klebstoffpunkte 10 auch in entsprechende Aussparungen des Klebebandes eingesetzt und in einem Arbeitsschritt mit diesem auf die Chipmodule 6 auflaminiert werden können.

Gemäß einer weiteren Ausführungsform der Erfindung werden die ausgestanzten Klebstoffpunkte 10 auf die Spulenkontaktflächen 3, 4 aufgebracht.

## Patentansprüche

1. Verfahren zur Herstellung einer elektrisch leitfähigen Verbindung zwischen Spulenkontaktflächen (3, 4) und Kontaktelementen (7) eines Chipmoduls (6) eines Datenträgers, insbesondere einer Chipkarte (1), unter Verwendung eines elektrisch leitenden Klebstoffs (8), **dadurch gekennzeichnet, dass** der Abstand (a) zwischen den Kontaktelementen (7) des Chipmoduls (6) und jeweils einer Spulenkontaktfläche (3, 4) um ein Vielfaches kleiner gewählt wird als der Abstand (d) zwischen den Spulenkontaktflächen (3, 4) und dass als Klebstoff ein begrenzt leitfähiger Klebstoff verwendet wird, dessen spezifische elektrische Leitfähigkeit derart gewählt wird, dass der Widerstand zwischen einem Kontaktelement (7) des Chipmoduls (6) und einer Spulenkontaktfläche (3, 4) einen geringen Wert von nicht mehr als 3 Ω aufweist und sich im Falle einer vollflächigen Klebeverbindung zwischen den Spulenkontaktflächen (3, 4) aufgrund des um ein Vielfaches größeren Abstands (d) der Spulenkontaktflächen (3, 4) und der geringen Querschnittsfläche über die Klebeverbindung ein hochohmiger Widerstand von mindestens 1000 Ω bildet.

2. Verfahren nach Anspruch 1, **dadurch gekennzeichnet, dass** der Klebstoff (8) mittels einer Klebeverbindung zwei Spulenkontaktflächen (3, 4) miteinander und beide Spulenkontaktflächen (3, 4) mit Kontaktelementen (7) des Chipmoduls (6) verbindet.

3. Verfahren nach einem der vorhergehenden Ansprüche, **dadurch gekennzeichnet, dass** der Klebstoff (8) ein Heißklebstoff ist.

4. Verfahren nach Anspruch 1 oder 3, **dadurch gekennzeichnet, dass** der Klebstoff (8) so aufgetragen wird, dass er keine mechanische Brücke zwischen den Spulenkontaktflächen (3, 4) bildet.

5. Verfahren nach einem der vorhergehenden Ansprüche, **dadurch gekennzeichnet, dass** der Klebstoff (8) auf den Spulenkontaktflächen (3, 4) in der Form von Klebstoffpunkten (10) aufgebracht wird.

6. Verfahren nach Anspruch 5, **dadurch gekennzeichnet, dass** die Klebstoffpunkte (10) nach dem Fräsen einer Chipmodulkavität aufgebracht werden.

7. Verfahren nach Anspruch 5 oder 6, **dadurch gekennzeichnet, dass** die Klebstoffpunkte (10) im Siebdruck aufgebracht werden.

8. Verfahren nach Anspruch 5 oder 6, **dadurch gekennzeichnet, dass** die Klebstoffpunkte (10) aus dem begrenzt leitfähigen Klebstoff (8) ausgestanzt werden.

9. Verfahren nach Anspruch 8, **dadurch gekennzeichnet, dass** die Klebstoffpunkte (10) in Aussparungen eines hitzeaktivierbaren Klebebands eingesetzt werden.

10. Verfahren nach Anspruch 9, **dadurch gekennzeichnet, dass** die Klebstoffpunkte (10) und das Klebeband in einem Arbeitsschritt auf ein Chipmodul (6) auflaminiert werden.

11. Verfahren nach einem der vorhergehenden Ansprüche, **dadurch gekennzeichnet, dass** das Chipmodul (6) durch einen nichtleitenden Klebstoff (9) am Substrat (5) befestigt wird.

12. Verfahren nach einem der vorhergehenden Ansprüche, **dadurch gekennzeichnet, dass** als Chipkarte (1) eine Dual-Interface-Karte gewählt wird.

13. Datenträger, insbesondere Chipkarte (1), mit einer durch einen elektrisch leitenden Klebstoff (8) gebildeten, elektrisch leitenden Verbindung zwischen Spulenkontaktflächen (3, 4) und Kontaktelementen (7) eines Chipmoduls (6), **dadurch gekennzeichnet, dass** der Abstand (a) zwischen den Kontaktelementen (7) des Chipmoduls (6) und jeweils einer Spulenkontaktfläche (3, 4) um ein Vielfaches kleiner ist als der Abstand (d) zwischen den Spulenkontaktflächen (3, 4) und dass der Klebstoff (8) ein Klebstoff (8) mit begrenzter elektrischer Leitfähigkeit ist, wobei der Widerstand zwischen einem Kontaktelement (7) des Chipmoduls (6) und einer Spulenkontaktfläche (3, 4) einen geringen Wert von nicht mehr als 3 Ω aufweist und wobei aufgrund des um ein Vielfaches größeren Abstands (d) der Spulenkontaktflächen (3, 4) und der geringen Querschnittsfläche ein hochohmiger Widerstand von mindestens 1000 Ω zwischen den Spulenkontaktflächen besteht oder bestehen würde, wenn der Klebstoff eine vollflächige Klebeverbindung zwischen den Spulenkontaktflächen bildet bzw. bilden würde.

## Claims

1. A method for producing an electroconductive connection between coil contact areas (3, 4) and contact elements (7) of a chip module (6) of a data carrier, in particular of a chip card (1), employing an electroconductive adhesive (8), **characterized in that** the distance (a) between the contact elements (7) of the chip module (6) and a respective coil contact area (3, 4) is chosen many times smaller than the distance (d) between the coil contact areas (3, 4), and that there is employed as an adhesive a limitedly conductive adhesive whose specific electrical conductivity is chosen such that the resistance between a contact element (7) of the chip module (6) and a coil contact area (3, 4) has a low value of no more than 3 Ω, and in the case of a full-area adhesive connection between the coil contact areas (3, 4) a high-ohmic resistance of at least 1000 Ω forms across the adhesive connection due to the many times greater distance (d) between the coil contact areas (3, 4) and the small cross-sectional area.

2. The method according to claim 1, **characterized in that** the adhesive (8) connects two coil contact areas (3, 4) to each other and the two coil contact areas (3, 4) to contact elements (7) of the chip module (6) by means of an adhesive connection.

3. The method according to either of the previous claims, **characterized in that** the adhesive (8) is a hot-melt adhesive.

4. The method according to claim 1 or 3, **characterized in that** the adhesive (8) is applied so as not to form a mechanical bridge between the coil contact areas (3, 4).

5. The method according to any of the previous claims, **characterized in that** the adhesive (8) is applied to the coil contact areas (3, 4) in the form of adhesive dots (10).

6. The method according to claim 5, **characterized in that** the adhesive dots (10) are applied after the milling of a chip module cavity.

7. The method according to claim 5 or 6, **characterized in that** the adhesive dots (10) are applied by screen printing.

8. The method according to claim 5 or 6, **characterized in that** the adhesive dots (10) are punched out of the limitedly conductive adhesive (8).

9. The method according to claim 8, **characterized in that** the adhesive dots (10) are inserted into gaps of a heat-activatable adhesive tape.

10. The method according to claim 9, **characterized in that** the adhesive dots (10) and the adhesive tape are laminated onto a chip module (6) in one working step.

11. The method according to any of the previous claims, **characterized in that** the chip module (6) is fastened to the substrate (5) by a non-conductive adhesive (9).

12. The method according to any of the previous claims, **characterized in that** as a chip card (1) there is chosen a dual interface card.

13. A data carrier, in particular chip card (1), having an electroconductive connection, which is formed by an electroconductive adhesive (8), between coil contact areas (3, 4) and contact elements (7) of a chip module (6), **characterized in that** the distance (a) between the contact elements (7) of the chip module (6) and a respective coil contact area (3, 4) is many times smaller than the distance (d) between the coil contact areas (3, 4), and that the adhesive (8) is an adhesive (8) with limited electroconductivity, whereby the resistance between a contact element (7) of the chip module (6) and a coil contact area (3, 4) has a low value of no more than 3 Ω, and whereby, due to the many times greater distance (d) between the coil contact areas (3, 4) and the small cross-sectional area, a high-ohmic resistance of at least 1000 Ω exists or would exist between the coil contact areas if the adhesive forms or would form a full-area connection between the coil contact areas.

## Revendications

1. Procédé d'établissement d'une connexion électroconductible entre des surfaces de contact de bobine (3, 4) et des éléments de contact (7) d'un module puce (6) d'un support de données, notamment d'une carte à puce (1), avec utilisation d'une colle (8) électroconductrice, **caractérisé en ce que** l'espacement (a) entre les éléments de contact (7) du module puce (6) et respectivement une surface de contact de bobine (3, 4) est sélectionné de manière à être inférieur d'un multiple à l'espacement (d) entre les surfaces de contact de bobine (3, 4) et **en ce que**, en tant que colle, une colle à conductibilité limitée est utilisée, dont la conductibilité électrique spécifique est sélectionnée de telle manière que la résistance entre un élément de contact (7) du module puce (6) et une surface de contact de bobine (3, 4) présente une valeur faible ne dépassant pas 3 Ω et que, dans le cas d'une connexion par collage à pleine surface entre les surfaces de contact de bobine (3, 4), en raison de l'espacement (d) supérieur d'un multiple des surfaces de contact de bobine (3, 4) et de la faible surface de section transversale, une résistance de valeur ohmique élevée d'au moins 1000 Ω à travers la connexion par collage se constitue.

2. Procédé selon la revendication 1, **caractérisé en ce que** la colle (8) relie au moyen d'une connexion par collage deux surfaces de contact de bobine (3, 4) ensemble et les deux surfaces de contact de bobine (3, 4) avec des éléments de contact (7) du module puce (6).

3. Procédé selon une des revendications précédentes, **caractérisé en ce que** la colle (8) est une colle thermofusible.

4. Procédé selon la revendication 1 ou 3, **caractérisé en ce que** la colle (8) est appliquée de telle manière qu'elle ne constitue pas de pont mécanique entre les surfaces de contact de bobine (3, 4).

5. Procédé selon une des revendications précédentes, **caractérisé en ce que** la colle (8) est appliquée sur les surfaces de contact de bobine (3, 4) sous forme de points de colle (10).

6. Procédé selon la revendication 5, **caractérisé en ce que** les points de colle (10) sont appliqués après le fraisage d'une cavité dans le module puce.

7. Procédé selon la revendication 5 ou 6, **caractérisé en ce que** les points de colle (10) sont appliqués par sérigraphie.

8. Procédé selon la revendication 5 ou 6, **caractérisé en ce que** les points de colle (10) sont découpés dans la colle (8) à conductibilité limitée.

9. Procédé selon la revendication 8, **caractérisé en ce que** les points de colle (10) sont insérés dans des évidements d'un ruban adhésif activable à chaud.

10. Procédé selon la revendication 9, **caractérisé en ce que** les points de colle (10) et le ruban adhésif sont laminés sur un module puce (6) lors d'une étape de la production.

11. Procédé selon une des revendications précédentes, **caractérisé en ce que** le module puce (6) est fixé au substrat (5) par une colle (9) non conductrice.

12. Procédé selon une des revendications précédentes, **caractérisé en ce que** c'est une carte dual interface qui est sélectionnée en tant que carte à puce (1).

13. Support de données, notamment carte à puce (1), comportant entre des surfaces de contact de bobine (3, 4) et des éléments de contact (7) d'un module puce (6) une connexion électroconductrice constituée par une colle (8) électroconductrice, **caractérisé en ce que** l'espacement (a) entre les éléments de contact (7) du module puce (6) et respectivement une surface de contact de bobine (3, 4) est inférieur d'un multiple à l'espacement (d) entre les surfaces de contact de bobine (3, 4) et **en ce que** la colle (8) est une colle (8) à conductibilité électrique limitée, tout **en ce que** la résistance entre un élément de contact (7) du module puce (6) et une surface de contact de bobine (3, 4) présente une valeur faible ne dépassant pas 3 Ω et, en raison de l'espacement (d) supérieur d'un multiple des surfaces de contact de bobine (3, 4) et de la faible surface de section transversale, une résistance de valeur ohmique élevée d'au moins 1000 Ω existe ou existerait entre les surfaces de contact de bobine si la colle constitue ou constituerait une connexion par collage à pleine surface entre les surfaces de contact de bobine.
